# EUROPEAN PATENT APPLICATION

(11) **EP 1 306 160 A1**
(43) Date of publication of application: **02.05.2003**
(21) Application number: 00929836.5
(22) Date of filing: 23.05.2000
(51) Int. Cl.: B23K 26/00, H05K 3/00

(54) **LASER DRILLING METHOD**

(71) Applicant: SUMITOMO HEAVY INDUSTRIES, LTD., Shinagawa-ku, Tokyo 141-8686 (JP)
(72) Inventor: KUWABARA, Takashi, Sumitomo Heavy Industries, Ltd, Hiratsuka-shi, Kanagawa 254-8010 (JP)
(74) Representative: Wagner, Karl H., Dipl.-Ing.
(86) International application number: JP0003285
(87) International publication number: WO01089756

(57) **Abstract**

An ultraviolet laser beam with a pulse width of 100-300 (nsec) is applied to a resin layer of a printed circuit board to make a hole.

## Description

### TECHNICAL FIELD

The present invention relates to a laser drilling method for carrying out perforation processing using a laser beam to a resin layer constituting a printed circuit board.

### BACKGROUND ART

Following the reduction in size and the densified packaging of electronic devices, the densification of circuits has been required for printed circuit boards. In response to such a requirement, a multilayer printed circuit board with a plurality of printed circuit boards being stacked in layers has been offered in recent years. In such a multilayer printed circuit board, it is necessary to electrically connect conductive layers with each other between vertically stacked printed circuit boards. The conductive layer is normally realized by a copper pattern. Such a connection is realized by forming, in an insulating resin layer of the printed circuit board, a hole called a via hole that reaches the lower conductive layer, and applying plating to the inside of the formed hole. Generally, a polymer material such as polyimide or epoxy resin is used for the insulating resin layer.

Recently, utilization of pulse-shaped laser beams has been started for such perforation processing. As compared with mechanical processing using a mechanical minute drill, a laser drilling apparatus using a laser beam is excellent in processing speed and capability of coping with the reduction in diameter of a hole. As a generation source of the laser beam, an excimer laser, a CO₂ laser, a YAG (yttrium aluminum garnet) laser or the like has been generally used.

With respect to excimer lasers, they are mainly used as generation sources of ultraviolet laser beams. In the excimer lasers, an oscillating wavelength can be changed by changing a kind of gas among KrF, ArF, XeF and XeCI. These lasers, however, are gas lasers, and oscillating times thereof, i.e. pulse widths, are generally about 10 to 20 (nsec) and thus are quite short. Therefore, when a pulse-shaped laser beam is applied to a processing object, energy of the laser beam is absorbed in the neighborhood of the surface of the processing object. This means that, with respect to a processing object having a certain thickness, the perforation capability of an excimer laser is lower as compared with the CO₂ laser or the YAG laser based on thermal processing. Since an absorption coefficient of laser beam energy to the processing object basically differs depending on the magnitude of a wavelength, a processing depth obtained by laser beam irradiation per pulse is limited. In other words, as the wavelength of a laser beam is shortened, the processing depth is reduced.

Accordingly, as compared with the CO₂ laser or a AG laser, the processing speed (perforation speed) of the excimer laser or of the triple wave, the quadruple wave or the quintuple wave (third harmonic, fourth harmonic or fifth harmonic) of an Nd;YLF laser, the Nd;YAG laser or an Nd;YVO₄ laser per pulse is lowered. Therefore, the drilling apparatuses having these ultraviolet light lasers as laser beam sources have a drawback in that the processing capability, particularly the processing speed, is low in the manner that depends on the wavelength of the ultraviolet laser beam.

Therefore, an object of the present invention is to improve the processing speed by properly setting a pulse width of a pulse laser beam when carrying out perforation processing to a printed circuit board or the like using an ultraviolet light pulse laser.

### DISCLOSURE OF THE INVENTION

The present invention is a drilling method for carrying out perforation by applying an ultraviolet laser beam to a printed circuit board, and is characterized by applying an ultraviolet laser beam having a pulse width of 100 to 300 (nsec) to a resin layer of a printed circuit board.

Particularly, in the present invention, an Nd;YLF pulse laser or an Nd;YAG pulse laser is used as a generation source of an ultraviolet laser beam.

### BRIEF DESCRIPTION OF THE DRAWING

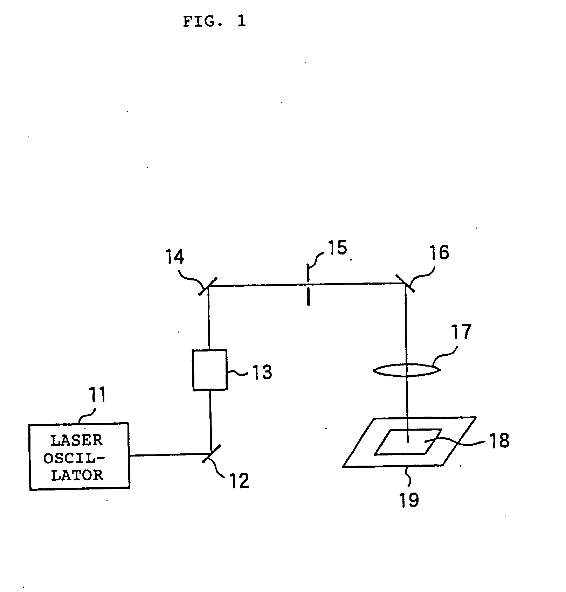

Fig. 1 is a diagram showing a system structure of a laser drilling apparatus applied with the present invention.

### BEST MODE FOR EMBODYING THE INVENTION

Hereinbelow, an embodiment of the present invention will be described. In the present invention, in order to improve the processing speed of perforation processing using an ultraviolet laser beam, attention is paid to a pulse width resulted from a structure of a laser oscillator. Specifically, in the laser oscillator, the pulse width can be adjusted by adjusting an interval of a pair of mirrors constituting a resonator.

Here, using lasers having different pulse widths, i.e. an XeF laser (wavelength: 351 nm) being an excimer laser and the third harmonic of an Nd;YLF pulse laser (wavelength: 351nm), the drilling performance of both lasers was compared. Specifically, the pulse width of the XeF laser is about 20 (nsec), and the pulse width of the third harmonic of the Nd;YLF pulse laser is about 170 (nsec).

Fig. 1 shows a system structure for carrying out perforation processing. As a laser oscillator 11, the XeF laser or the Nd;YLF pulse laser is used. Particularly, in case of the Nd;YLF pulse laser, the third harmonic thereof is used. A laser beam generated by the laser oscillator 11 is applied to a mask 15 via a reflecting mirror 12, an attenuator 13 and a reflecting mirror 14. An image defined by an opening of the mask 15 is projected onto a processing object 18 in a scale-down fashion through a processing lens 17 called an f lens, via a reflecting mirror 16. The processing object 18 is mounted on an X-Y stage 19. The X-Y stage 19 can move a table with the processing object 18 mounted thereon, in an X-axis direction and a Y-axis direction. As a result, perforation using the laser beam can be implemented at a desired position of the processing object 18.

The attenuator 13 is arranged for adjusting energy of the high-output XeF laser. Therefore, in case of using the Nd;YLF pulse laser, it may be omitted. In this manner, in case of using either the XeF laser or the Nd;YLF pulse laser, it was adjusted such that the fluence (energy density) of the laser beam on the processing object 18 became approximately equal.

As the processing object 18, a polyimide film (Kapton film: thickness: 100µm⁺) was used. No difference exists in wavelength between the foregoing two lasers, and a difference exists only in pulse width therebetween. Using the XeF laser and the third harmonic of the Nd;YLF pulse laser, the processing was attempted with irradiation energy of 10 (J/cm²) on the surface of the processing object in both cases. As a result, the processing depth per pulse was about 2 (µm) in case of the XeF laser, and about 7 (µm) in case of the Nd;YLF pulse laser.

From the foregoing result, it is understood that the third harmonic of the Nd;YLF pulse laser is higher in perforation capability. The reason for this is that if the pulse width is shortened, the laser beam application is finished in a short time, so that the laser beam energy is accumulated in the neighborhood of the surface of the processing object and thus penetration of the quantity of heat into the processing object is low. On the other hand, it is supposed that if the pulse width of the laser beam is long, since thermal diffusion into the processing object is large, an ablation reaction or a thermal alteration of a beam applied portion due to the heat is accelerated, so that the perforation speed is improved.

The foregoing point is applicable to the fundamental wave and the second to fifth harmonics of the Nd;YLF pulse laser or the Nd;YAG pulse laser. For example, even in case of the third harmonic of the Nd;YAG pulse laser with a pulse width of 150 (nsec), the perforation speed was increased. It has been confirmed that the range of desirable pulse widths is 100 to 300 (nsec).

As described above, according to the present invention, the processing speed (perforation speed) can be improved by properly setting a pulse width of a pulse laser beam when carrying out perforation processing to a printed circuit board or the like using an ultraviolet light pulse laser, particularly an Nd;YLF pulse laser or an Nd;YAG pulse laser.

### INDUSTRIAL APPLICABILITY

The present invention is considered to be applied to perforation processing relative to a resin layer of a printed circuit board, perforation to an organic material such as polymer, or the like.

## Claims

1. A laser drilling method for implementing perforation by applying an ultraviolet laser beam to a printed circuit board, **characterized by** applying the ultraviolet laser beam having a pulse width of 100 to 300 (nsec) to a resin layer of the printed circuit board.

2. A laser drilling method for implementing perforation by applying a laser beam to a printed circuit board, **characterized by** applying the laser beam having a pulse width of 100 to 300 (nsec) to a resin layer of the printed circuit board, using an Nd;YLF pulse laser or an Nd;YAG pulse laser.

3. A laser drilling method as set forth in claim 2, **characterized in that** said printed circuit board has a conductive layer under the resin layer, and processing of said perforation is to form a hole reaching said conductive layer.

4. A laser drilling method as set forth in claim 2 or 3, **characterized in that** said laser beam is any one of the fundamental wave and the second to fifth harmonics of said Nd;YLF pulse laser or said Nd;YAG pulse laser.

## Amended claims

### Amended claims under Art. 19.1 PCT

**1.** A laser drilling method for implementing perforation by applying an ultraviolet laser beam to a printed circuit board, **characterized by** applying the ultraviolet laser beam having a pulse width of 100 to 300 (nsec) to a resin layer of the printed circuit board.

**2.** A laser drilling method for implementing perforation by applying a laser beam to a printed circuit board, **characterized by** applying the laser beam having a pulse width of 100 to 300 (nsec) to a resin layer of the printed circuit board, using an Nd;YLF pulse laser or an Nd;YAG pulse laser.

**3.** A laser drilling method as set forth in claim 2, **characterized in that** said printed circuit board has a conductive layer under the resin layer, and processing of said perforation is to form a hole reaching said conductive layer.

**4.** A laser drilling method as set forth in claim 2 or 3, **characterized in that** said pulse laser is any one of the fundamental wave and the second to fifth harmonics of said Nd;YLF pulse laser or said Nd;YAG pulse laser.

**5.** (Added) A laser drilling apparatus for implementing perforation by applying a laser beam to a resin board, said apparatus comprising, as means for generating said laser beam, means for generating harmonics of an Nd;YLF pulse laser or an Nd;YAG pulse laser, said pulse laser having a pulse width selected between 100-300 (nsec).

**6.** (Added) A laser drilling apparatus as set forth in claim 5, wherein a mask is disposed in an optical path of said laser beam and a fθ lens is disposed in an optical path between said mask and said resin board to project an image of said mask onto said resin board at a reduced scale.
